(19) Europäisches Patentamt / European Patent Office / Office européen des brevets

(11) **EP 2 721 430 B1**

(12) **FASCICULE DE BREVET EUROPEEN**

(45) Date de publication et mention
de la délivrance du brevet:
**05.08.2015 Bulletin 2015/32**

(21) Numéro de dépôt: **12730836.9**

(22) Date de dépôt: **13.06.2012**

(51) Int Cl.:
***G01S 7/41*** *(2006.01)*

(86) Numéro de dépôt international:
**PCT/EP2012/061192**

(87) Numéro de publication internationale:
**WO 2012/171953 (20.12.2012 Gazette 2012/51)**

(54) **MÉTHODE D'ESTIMATION DE SURFACE ÉQUIVALENTE RADAR À PARTIR DE MESURES EN CHAMP PROCHE**

VERFAHREN ZUR BESTIMMUNG EINES ÄQUIVALENTEN RADARQUERSCHNITTS AUF BASIS VON NAHFELDMESSUNGEN

METHOD OF ESTIMATING EQUIVALENT RADAR CROSS SECTION ON THE BASIS OF NEAR-FIELD MEASUREMENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.06.2011 FR 1155338**

(43) Date de publication de la demande:
**23.04.2014 Bulletin 2014/17**

(73) Titulaire: **Commissariat à l'Énergie Atomique et aux Énergies Alternatives 75015 Paris (FR)**

(72) Inventeurs:
• **MORVAN, Sylvain**
**33000 Bordeaux (FR)**
• **VACUS, Olivier**
**F-33610 Cestas (FR)**

(74) Mandataire: **Ahner, Philippe
BREVALEX
95, rue d'Amsterdam
75378 Paris Cedex 8 (FR)**

(56) Documents cités:
**FR-A1- 2 914 750**

• **LAHAIE I J ET AL: "Far field radar cross-section (RCS) predictions from planar near field measurements", PROCEEDINGS OF THE ANTENNAS AND PROPAGATION SOCIETY INTERNATIONAL SYMPOSIUM (APSIS). CHICAGO, JULY 20 - 24, 1992; [PROCEEDINGS OF THE ANTENNAS AND PROPAGATION SOCIETY INTERNATIONAL SYMPOSIUM (APSIS)], NEW YORK, IEEE, US, vol. -, 18 juillet 1992 (1992-07-18), pages 1542-1545, XP010065778, DOI: 10.1109/APS.1992.221744 ISBN: 978-0-7803-0730-8**

• **MARIE A C ET AL: "A near-field bistatic radar cross section calibration method", ANTENNAS AND PROPAGATION INTERNATIONAL SYMPOSIUM, 2007 IEEE, IEEE, PISCATAWAY, NJ, USA, 1 juin 2007 (2007-06-01), pages 4613-4616, XP031170215, ISBN: 978-1-4244-0877-1**

• **LAHAIE I J: "Overview of an image-based technique for predicting far-field radar cross section from near-field measurements", IEEE ANTENNAS AND PROPAGATION MAGAZINE, IEEE SERVICE CENTER, PISCATAWAY, NJ, US, vol. 45, no. 6, 1 décembre 2003 (2003-12-01), pages 159-169, XP011110374, ISSN: 1045-9243, DOI: 10.1109/MAP.2003.1282192**

EP 2 721 430 B1

**Description**

## DOMAINE TECHNIQUE

La présente invention concerne le domaine de la signature radar et, plus particulièrement de la détermination d'une surface équivalente radar.

## ÉTAT DE LA TECHNIQUE ANTÉRIEURE

La surface équivalente radar ou SER est une grandeur fondamentale caractéristique d'une cible. Elle est utilisée tant dans le domaine militaire que dans le domaine civil (par exemple pour le contrôle aérien) aux fins de discrimination d'un objet, typiquement d'un aéronef.

La SER d'une cible radar est définie de manière classique à partir du bilan de puissance de l'onde émise en direction de la cible et de la puissance de l'onde reçue par le radar. En champ lointain et en approximant les ondes à des ondes planes, l'équation radar s'écrit en effet :

$$P_r = P_e G_e \frac{1}{4\pi d^2} \sigma \frac{1}{4\pi d^2} G_r \frac{\lambda^2}{4\pi} \qquad (1)$$

où $P_e$ et $P_r$ sont respectivement les puissances des ondes émise et reçue par le radar, $G_e$ et $G_r$ les gains d'antenne à l'émission et à la réception, $d$ la distance entre le radar et la cible, $\lambda$ la longueur d'onde utilisée par le radar. Le coefficient $\sigma$ est homogène à une surface et ne dépend que de la cible considérée, c'est la SER de la cible.

On trouvera une description plus détaillée de la SER notamment dans l'ouvrage de G.T. Tuck et al. intitulé « Radar cross-section Handbook » chez Peninsula Publishing.

Dans l'expression (1) on a supposé que le radar servant à illuminer la cible était le même que celui servant à la réception de l'onde diffractée, on parle alors de SER monostatique. En règle générale, la SER monostatique dépend de la direction de l'onde incidente, de la fréquence $f$ du radar et des polarisations respectives $\pi_e$ et $\pi_r$ avec lesquelles l'onde incidente est émise et l'onde reçue est analysée. On la note $SER(f, \varphi, \theta, \pi_e, \pi_r)$, où $(\varphi, \theta)$ sont les angles de gisement et de roulis du radar dans un référentiel lié à la cible. Chacune des polarisations $\pi_e$ et $\pi_r$ peut être horizontale ou verticale, c'est-à-dire $\pi_e = H$ ou $V$; $\pi_r = H$ ou $V$.

De manière similaire, si le système radar est bistatique, c'est-à-dire si le radar servant à analyser l'onde diffractée est distinct de celui qui sert à illuminer la cible, on parle de SER bistatique. Celle-ci ne dépend plus alors seulement de la direction de l'onde incidente, mais aussi de la direction de l'onde diffractée. On la note $SER(f, \varphi_e, \theta_e, \varphi_r, \theta_r, \pi_e, \pi_r)$ où $(\theta_e, \varphi_e)$, resp. $(\theta_r, \varphi_r)$, sont les angles de gisement et de roulis de l'onde incidente, respectivement de l'onde diffractée.

La SER d'un objet peut être mesurée ou bien estimée par simulation.

Ces deux méthodes présentent toutefois de nombreuses limitations.

La mesure de SER est classiquement réalisée dans un local anéchoïque, au moyen d'une seule antenne, soit au moyen de deux antennes distinctes légèrement décalées angulairement l'une par rapport à l'autre. Selon le cas on obtient les valeurs de SER monostatique ou de SER quasi-monostatique, pour un angle ou une pluralité d'angles de gisement. Les mesures ne peuvent être réalisées en pratique que selon quelques angles de gisement dans un plan équatorial de sorte que l'on ne dispose que d'une représentation bidimensionnelle assez sommaire de la cible. L'obtention d'une SER tridimensionnelle par mesure est très rare et bien souvent impossible.

En outre, les mesures sont souvent affectées par des bruits de sources diverses (échos parasites, bruit d'instrumentation etc.), ce problème étant aggravé dans le régime des basses fréquences (longueur d'onde supérieure ou très supérieure aux dimensions caractéristiques de l'objet), où l'efficacité des absorbants est moindre.

L'estimation de la SER par simulation peut alternativement être réalisée par la méthode dite des points brillants. Selon cette méthode, la cible est décomposée en un ensemble de contributeurs élémentaires indépendants (ou points brillants), chaque contributeur étant affecté d'un coefficient de pondération. En d'autres termes, l'onde diffractée est alors considérée comme la somme d'une pluralité d'ondes sphériques, chaque onde sphérique étant émise par un point brillant. La SER de la cible peut alors s'exprimer comme :

$$\sigma = \left| \sum_{n=1}^{N} a_n e^{i\vec{k}\vec{u}_n} \right| \qquad (2)$$

où les $a_n$, $n=1,..,N$ sont les coefficients de pondération complexes des différents contributeurs, $\vec{u}_n$ sont les vecteurs donnant leurs positions respectives et $\vec{k}$ est le vecteur d'onde de l'onde diffractée.

La méthode des points brillants s'avère toutefois excessivement difficile à mettre en oeuvre pour des formes de cible complexes et en tout état de cause n'est pas applicable dans le régime des basses fréquences.

Une méthode de détermination de la SER à partir d'un modèle de diffraction de la cible et de mesures dans une pluralité de directions a été divulguée dans le brevet EP-B-2132586, déposé au nom de la présente Demanderesse.

En substance, le modèle de diffraction est représenté par une matrice de rapports d'amplitudes complexes d'onde diffractée par la cible et d'onde incidente, chaque rapport étant relatif à un couple de directions de l'onde incidente et d'observation de l'onde diffractée. Cette matrice fait ensuite l'objet d'une décomposition modale, seuls les vecteurs modaux les plus significatifs étant sélectionnés. On projette ensuite le vecteur de mesure sur ces vecteurs modaux sélectionnés et on en déduit un vecteur reconstruit dont les composantes sont représentatives de rapports d'amplitudes complexes d'onde incidente et d'onde diffractée pour les couples de directions et de polarisations du modèle. La SER est ensuite calculée à partir des composantes du vecteur reconstruit.

Cette méthode hybride, au sens où elle s'appuie à la fois sur un modèle de diffraction et sur des mesures, donne des résultats satisfaisants pour autant que les ondes utilisées pour la mesure puissent être assimilées à des ondes planes, c'est-à-dire lorsque la mesure est réalisée en champ lointain. Cette approximation est généralement valable pour les hautes fréquences (longueurs d'onde faibles par rapport aux dimensions caractéristiques de la cible), lorsque les antennes d'émission/ réception sont situées loin de la cible. Toutefois en régime basse fréquence et/ou lorsque les antennes en question sont proches de la cible cette approximation n'est plus valable et la valeur de la SER peut être erronée.

Le but de l'invention est par conséquent de proposer une méthode d'estimation de SER qui ne présente pas les inconvénients précités, à savoir une méthode qui permette une détermination correcte de la SER lorsque l'hypothèse de champ lointain n'est pas vérifiée.

## EXPOSÉ DE L'INVENTION

La présente invention est définie comme une méthode d'estimation de surface équivalente radar d'un objet donné à partir d'un premier modèle de diffraction en champ lointain dudit objet et d'un second modèle de diffraction en champ proche dudit objet, les premier et second modèles pouvant être respectivement représentés par une première matrice **(A$_b$)** et une seconde matrice **(A'$_b$)** de rapports d'amplitudes complexes d'onde diffractée et d'onde incidente, pour une pluralité ($4N^2$) de couples de directions et de polarisations respectives de l'onde incidente et d'observation de l'onde diffractée, dans laquelle :

- on effectue une décomposition modale desdites première et seconde matrices et l'on sélectionne les vecteurs modaux **(V,V)** les plus significatifs de la première et de la seconde matrices ainsi décomposées pour obtenir une première base et une seconde base de vecteurs modaux ;
- on établit une correspondance entre vecteurs modaux de la première base et vecteurs modaux de la seconde base ;
- on détermine un opérateur (F) permettant de passer des secondes valeurs modales ($\lambda'^s$) associées aux vecteurs modaux de la seconde base aux premières valeurs modales ($\lambda^s$) associées aux vecteurs modaux correspondants de la première base ;
- on effectue une pluralité ($N^\mu$) de mesures de rapports d'amplitudes complexes d'onde diffractée et d'onde incidente en champ proche pour une pluralité de couples de directions et au moins un couple de polarisations respectives de l'onde incidente et d'observation de l'onde diffractée ;
- on projette le vecteur **(a'$^\mu$)**, formé par les rapports ainsi mesurés, sur lesdits vecteurs modaux de la seconde base, pour obtenir des secondes composantes modales **($\lambda'^\mu$)** sur cette base;
- on obtient des premières composantes modales ($\lambda^\mu$) sur la première base modale en appliquant ledit opérateur aux secondes composantes modales ;
- on génère à partir des premières composantes modales et des vecteurs modaux de la première base un vecteur reconstruit **(ã)** dont les composantes sont représentatives des rapports d'amplitudes complexes d'onde incidente et diffractée pour ladite pluralité de couples de directions et de polarisations ;
- on détermine la surface équivalente radar à partir d'au moins une composante du vecteur reconstruit.

Selon une première variante ladite décomposition modale est une diagonalisation et :

- les vecteurs modaux de la première base et les premières valeurs modales sont respectivement les vecteurs propres et les valeurs propres de la première matrice ;
- les vecteurs modaux de la seconde base et les secondes valeurs modales sont respectivement les vecteurs propres et les valeurs propres de la seconde matrice.

Selon une troisième variante, ladite décomposition modale est une décomposition en valeurs singulières et :

- les vecteurs modaux de la première base et les premières valeurs modales sont respectivement les vecteurs singuliers et les valeurs singulières de la première matrice ;
- les vecteurs modaux de la seconde base et les secondes valeurs modales sont respectivement les vecteurs singuliers et les valeurs singulières de la seconde matrice.

Ladite correspondance peut être établie en recherchant pour chaque vecteur modal de la seconde base, le vecteur modal de la première base qui lui est le plus proche.

Alternativement, ladite correspondance peut être établie de proche en proche entre les vecteurs modaux de la première base et les vecteurs modaux de la seconde base, au moyen d'une pluralité d'opérations successives, chaque association étant relative à une base de vecteurs modaux intermédiaire.

Ledit opérateur peut être défini par **F=Diag**$(\lambda_s/\lambda'_s)$ où $\lambda_s, \lambda'_s$ sont respectivement les premières et secondes valeurs modales et **Diag(.)** est la matrice diagonale de rang s, égal au nombre de vecteurs modaux de la première/seconde base.

Alternativement, ledit opérateur est défini par une matrice pseudo-inverse minimisant la distance entre $F(\lambda'^s)$ et $\lambda^s$ pour un ensemble de couples $\lambda'^s_p$ , $\lambda^s_p$ , $p = 1,...,P$, où $\lambda^s_p$ et $\lambda'^s_p$ sont des premières et secondes valeurs modales obtenues par $P$ simulations respectives du premier et du second modèles de diffraction.

Les secondes composantes modales sont avantageusement déterminées par :

$$\lambda'^\mu = \left(\mathbf{V}'^\mu\right)^\dagger \mathbf{a}'^\mu$$

où $\lambda'^\mu$ représente le vecteur des secondes composantes modales, $(\mathbf{V}'^\mu)^+$ est la matrice pseudo-inverse de $\mathbf{V}'^\mu$, $\mathbf{V}'^\mu$ est la matrice dont les colonnes sont lesdits vecteurs modaux de la seconde base et dont les lignes correspondent à la seconde pluralité de rapports mesurés.

On peut ensuite générer le vecteur reconstruit, $\tilde{\mathbf{a}}$, par $\tilde{\mathbf{a}} = \mathbf{V}^s\lambda^\mu$ où $\mathbf{V}^s$ est la matrice dont les colonnes sont lesdits vecteurs modaux de la première base et dont les lignes correspondent à la première pluralité de rapports du premier modèle.

La surface équivalente radar $(\widetilde{\sigma}_{ij}^{\pi_c \pi_r})$ pour un couple de directions d'onde incidente et d'observation d'onde diffractée et un couple de polarisations associées peut alors être obtenue à partir du module au carré $(\left|\widetilde{a}_{ij}^{\pi_c \pi_r}\right|^2)$ d'une composante dudit vecteur reconstruit.

La matrice pseudo-inverse de $\mathbf{V}'^\mu$ peut être obtenue par $(\mathbf{V}'^\mu)^\dagger = (\mathbf{V}'^{\mu H}\mathbf{V}'^\mu)^{-1} \mathbf{V}'^{\mu H}$, la matrice $\mathbf{V}'^\mu$ faisant préalablement l'objet d'un reconditionnement matriciel si le nombre de conditionnement de la matrice $\mathbf{V}'^{\mu H}\mathbf{V}'^\mu$ est supérieur à un seuil prédéterminé $(cond_T)$.

L'invention concerne également un programme d'ordinateur comprenant des moyens logiciels adaptés à mettre en oeuvre les étapes de la méthode d'estimation, lorsqu'il est exécuté par un ordinateur.

## BRÈVE DESCRIPTION DES DESSINS

D'autres caractéristiques et avantages de l'invention apparaîtront à la lecture d'un mode de réalisation préférentiel de l'invention fait en référence aux figures jointes parmi lesquelles :

La Fig. 1 représente l'organigramme d'un procédé d'estimation de SER à partir de mesures en champ proche, selon un mode de réalisation de l'invention ;
Les Fig. 2 à 4 représentent de manière schématique des variantes du procédé de reconditionnement matriciel, utile pour certains modes de réalisation de l'invention.

## EXPOSÉ DÉTAILLÉ DE MODES DE RÉALISATION PARTICULIERS

On considérera dans la suite une cible dont on souhaite estimer la SER monostatique ou bistatique, que ce soit en haute fréquence ou en basse fréquence, au sens défini plus haut.

De manière générale, pour une fréquence $f$ donnée, la description de la SER bistatique de la cible peut s'exprimer sous forme d'une matrice de taille $2N \times 2N$ :

$$\boldsymbol{\Sigma}_b = \begin{pmatrix} \sigma_{11}^{HH} & \sigma_{12}^{HH} & \cdots & \sigma_{1N}^{HH} & \sigma_{11}^{HV} & \sigma_{12}^{HV} & \cdots & \sigma_{1N}^{HV} \\ \sigma_{21}^{HH} & \sigma_{22}^{HH} & \cdots & \sigma_{2N}^{HH} & \sigma_{21}^{HV} & \sigma_{22}^{HV} & \cdots & \sigma_{2N}^{HV} \\ \vdots & \vdots & \ddots & \vdots & \vdots & \vdots & \ddots & \vdots \\ \sigma_{N1}^{HH} & \sigma_{N2}^{HH} & \cdots & \sigma_{NN}^{HH} & \sigma_{N1}^{HV} & \sigma_{N2}^{HV} & \cdots & \sigma_{NN}^{HV} \\ \sigma_{11}^{VH} & \sigma_{12}^{VH} & \cdots & \sigma_{1N}^{VH} & \sigma_{11}^{VV} & \sigma_{12}^{VV} & \cdots & \sigma_{1N}^{VV} \\ \sigma_{21}^{VH} & \sigma_{22}^{VH} & \cdots & \sigma_{2N}^{VH} & \sigma_{21}^{VV} & \sigma_{22}^{VV} & \cdots & \sigma_{2N}^{VV} \\ \vdots & \vdots & \ddots & \vdots & \vdots & \vdots & \ddots & \vdots \\ \sigma_{N1}^{VH} & \sigma_{N2}^{VH} & \cdots & \sigma_{NN}^{VH} & \sigma_{N1}^{VV} & \sigma_{N2}^{VV} & \cdots & \sigma_{NN}^{VV} \end{pmatrix} \qquad (3)$$

où chaque élément $\sigma_{ij}^{\pi_e \pi_r}$ est la valeur de la SER observée pour une onde incidente de direction $\vec{u}_i^e$ de polarisation $\pi_e = H$ ou $V$ et pour une direction de réception $\vec{u}_j^r$ avec une polarisation $\pi_r = H$ ou $V$. Les directions $\vec{u}_i^e$ et $\vec{u}_j^r$, $i,j = 1,..,N$ sont avantageusement mais non nécessairement équiréparties à l'intérieur de l'angle solide $4\pi$. Par exemple, ces directions peuvent être équiréparties angulairement en gisement et roulis. On comprendra que plus $N$ est élevé, plus la description de la SER sera précise. On choisira avantageusement $N$ de manière à ce que l'échantillonnage selon l'angle de gisement et l'angle de roulis respecte le critère de Nyquist.

La matrice $\Sigma_b$ est à valeurs réelles positives. On introduit la matrice de diffraction $\mathbf{A_b}$ à valeurs complexes dont les éléments ne sont pas des rapports de puissance mais des rapports d'amplitudes complexes de l'onde reçue et de l'onde incidente, autrement dit, $\mathbf{A_b} = \left( a_{ij}^{\pi_e \pi_r} \right)$, $i,j = 1,..,N$, $\pi_e = H$ ou $V$, $\pi_r = H$ ou $V$ avec $a_{ij}^{\pi_e \pi_r} = \sqrt{\sigma_{ij}^{\pi_e \pi_r}} \exp(i\,\psi_{ij}^{\pi_e \pi_r})$ à un coefficient multiplicatif près, où $\psi_{ij}^{\pi_e \pi_r}$ traduit le déphasage subi par l'onde diffractée par rapport à l'onde incidente. L'élément $a_{ij}^{\pi_e \pi_r}$ est encore dénommé coefficient de rétrodiffusion, relativement à l'onde incidente selon la direction $i$ et la polarisation $\pi_e$ et à l'onde diffractée observée dans la direction $j$ et analysée selon la polarisation $\pi_r$.

Comme dans l'art antérieur précité, la méthode d'estimation de SER selon l'invention part d'une matrice $\mathbf{A_b}$ la plus complète possible, c'est-à-dire dont on connaît le plus grand nombre possible d'éléments $a_{ij}^{\pi_e \pi_r}$, aussi bien en termes de directions d'émission $\vec{u}_e$ et de réception $\vec{u}_r$ qu'en termes de polarisations $\pi_e$, $\pi_r$. Cette matrice peut être obtenue avec plus ou moins de précision et pour un plus ou moins grand nombre d'éléments, soit par le calcul grâce à une modélisation de l'objet si sa forme n'est pas trop complexe, soit par une campagne de mesures effectuées sur une maquette de l'objet à échelle réduite. La matrice $\mathbf{A_b}$ constitue un modèle de diffraction de l'objet.

Lorsque la surface de la cible est parfaitement conductrice, la matrice $\mathbf{A_b}$ peut s'écrire comme :

$$\mathbf{A_b} = \mathbf{W D W^{-1}} \qquad (4)$$

où $\mathbf{D} = \mathbf{diag}(\lambda_1,...,\lambda_{2N})$ est la matrice diagonale ayant pour éléments les valeurs propres $\lambda_1,..,\lambda_{2N}$ de $\mathbf{A_b}$ et où $\mathbf{W}$ est la matrice de changement de base.

La matrice $\mathbf{A_b}$ peut s'exprimer grâce à la décomposition modale :

$$\mathbf{A_b} = \sum_{k=1}^{2N} \lambda_k \mathbf{V_k} \quad \text{avec} \quad \mathbf{V_k} = \mathbf{W I_k W^{-1}} \qquad (5)$$

où $\mathbf{I_k}$ est une matrice de taille $2N \times 2N$ nulle partout à l'exception du $k$ième de sa diagonale égal à 1.

Si la surface de la cible n'est pas parfaitement conductrice mais simplement diélectrique, la matrice $\mathbf{A_b}$ n'est plus diagonalisable. Elle peut toutefois faire l'objet d'une décomposition en valeurs singulières :

$$\mathbf{A_b} = \mathbf{UDV^H} \tag{6}$$

où $\mathbf{D} = \mathbf{diag}(\lambda_1,..,\lambda_{2N})$ est la matrice diagonale ayant pour éléments les valeurs singulières $\lambda_1,..,\lambda_{2N}$ de $\mathbf{A_b}$, $\mathbf{U}$ et $\mathbf{V}$ sont des matrices unitaires et $\mathbf{V^H}$ est la transposée conjuguée de $\mathbf{V}$. La matrice $\mathbf{A_b}$ peut alors s'écrire, de manière similaire à (5) :

$$\mathbf{A_b} = \sum_{k=1}^{2N} \lambda_k \mathbf{V_k} \quad \text{avec} \quad \mathbf{V_k} = \mathbf{UI_k V^H} \tag{7}$$

Par la suite nous nous référerons aux valeurs propres ou aux valeurs singulières sous l'expression plus générale de valeurs modales.

Dans les deux cas, si l'on définit le vecteur $\mathbf{a_b}$ de taille $4N^2$ comme la concaténation des $2N$ vecteurs colonne de la matrice $\mathbf{A_b}$ et, de manière similaire, le vecteur $\mathbf{v_k}$ comme la concaténation des vecteurs colonne de la matrice $\mathbf{V_k}$, la relation (7) s'écrit de manière vectorielle :

$$\mathbf{a_b} = \sum_{k=1}^{2N} \lambda_k \mathbf{v_k} \tag{8}$$

ou encore si l'on note respectivement $\lambda$ le vecteur ayant pour composantes les valeurs modales et $\mathbf{V}$ la matrice de taille $2Nx2N$ dont les colonnes sont constituées par les vecteurs $\mathbf{v_k}$ :

$$\mathbf{a_b} = \mathbf{V}\lambda \tag{9}$$

Chacun des vecteurs $\mathbf{v_k}$ correspond à l'excitation d'un courant caractéristique de la cible et donc à la génération d'une onde caractéristique. Dans la suite, les vecteurs $\mathbf{v_k}$ sont également dénommés vecteurs modaux en champ lointain. Les modes les plus significatifs, c'est-à-dire les plus énergétiques, sont sélectionnés.

Après sélection des modes les plus énergétiques, l'expression (8) se réduit à :

$$\widetilde{\mathbf{a}}_\mathbf{b} = \sum_{k \in S} \lambda_k \mathbf{v_k} \tag{10}$$

où $S$ est l'ensemble des modes sélectionnés. De manière équivalente, cela revient à réduire la dimensionnalité de $\lambda$ et de $\mathbf{V}$ :

$$\widetilde{\mathbf{a}}_\mathbf{b} = \mathbf{V^s}\lambda^\mathbf{s} \tag{11}$$

où le vecteur $\lambda^\mathbf{s}$ est obtenu en éliminant de $\lambda$ les composantes non sélectionnées et, de même, la matrice $\mathbf{V^s}$ est obtenue à partir de $\mathbf{V}$ en supprimant les vecteurs colonne non sélectionnés. $\mathbf{V^s}$ est une matrice de taille $4N^2 \times s$ où $s=Card(S)$ est le nombre de modes sélectionnés.

On obtient ainsi un modèle de diffraction, simplifié mais néanmoins pertinent de l'objet. Les vecteurs modaux $\mathbf{v_k}$, $k \in S$, c'est-à-dire les vecteurs colonne de $\mathbf{V^s}$, engendrent un espace $E^s$, sous-espace de l'espace $E_{2N}$ engendré par les vecteurs $\mathbf{v_k}$, $k = 1,..,2N$.

On notera que le modèle de diffraction est identique à celui utilisé dans l'art antérieur précité, et qu'il s'agit d'un modèle de diffraction en champ lointain, au sens défini ci-après.

A la différence de l'art antérieur, des mesures de coefficients de rétrodiffusion sont effectuées en champ proche sur la cible à l'aide d'un aérien faisant office d'antenne d'émission/réception.

On entend ici par champ proche un champ qui ne vérifie pas les conditions de champ lointain. On rappelle qu'un champ est dit lointain si la distance $L_b$ de l'aérien à la cible (également dénommée longueur de base) est supérieure à la distance de Rayleigh définie par :

$$L_R = \frac{2D^2}{\lambda} \qquad\qquad (12)$$

où D est la dimension caractéristique de la cible et $\lambda$ est la longueur d'onde. En champ proche, l'onde présente un caractère sphérique, autrement dit une composante non nulle de champ dans la direction de propagation. De manière générale, une mesure sera dite effectuée en champ proche si la distance de l'antenne d'émission et/ou de réception à la cible est inférieure à la distance $L_R$ de la cible.

De manière similaire au modèle de diffraction en champ lointain (défini par la base des vecteurs modaux $\mathbf{v_k}$, $k \in S$), on élabore un modèle de diffraction en champ proche. Ce modèle de diffraction, comme le précédent, est nécessaire à l'exploitation des mesures et sera décrit ci-après.

On considère d'abord un modèle de l'aérien utilisé pour les mesures. Ce modèle peut être obtenu en maillant une représentation de l'aérien et en résolvant les équations de Maxwell sur le réseau maillé, de manière connue en soi. On peut alors calculer le champ au niveau de la cible à partir de l'amplitude complexe de l'excitation de l'aérien, puis le champ diffracté et enfin l'amplitude complexe reçue, autrement dit le paramètre $S_{11}$ de l'ensemble aérien plus cible. On suppose pour ce faire que la longueur de base est la même que dans le cas de la mesure réelle. Le cas échéant, d'autres éléments de l'environnement de la cible, tels que les parois du local anéchoïque, le positionneur, etc. peuvent être également modélisés et pris en compte dans la simulation précédente. Alternativement, l'aérien peut être modélisé sous la forme d'un ensemble équivalent de dipôles élémentaires, disposés de manière à ce que la somme des champs respectivement générés par ces dipôles soit sensiblement égale au champ généré par l'aérien sur la cible. En d'autres termes, la génération par l'aérien d'une onde donnée est équivalente à la génération d'ondes élémentaires respectives par les dipôles en question. De manière symétrique, l'onde diffractée se traduit par une pluralité d'amplitudes complexes de l'onde diffractée, telle que reçue par les différents dipôles. A partir de ces amplitudes complexes, on peut déterminer ensuite l'amplitude complexe de l'onde diffractée que recevrait l'aérien. La même simulation peut être réalisée en bistatisme, c'est-à-dire pour un aérien d'émission et un aérien de réception, chaque aérien étant décomposé en un ensemble de dipôles élémentaires.

Enfin, comme précédemment, le modèle de diffraction en champ proche obtenu par simulation peut être complété par des valeurs mesurées sur un modèle réduit de la cible.

Dans tous les cas, le modèle de diffraction en champ proche se traduit par une matrice $\mathbf{A'_b} = \left( a'^{\pi_e \pi_r}_{ij} \right)$ où les $a'^{\pi_e \pi_r}_{ij}$ sont des rapports d'amplitudes complexes de l'onde reçue et de l'onde incidente en champ proche pour les directions $i$ et $j$, pour les polarisations $\pi_e$ et $\pi_r$. La matrice $\mathbf{A'_b}$ est de même taille que la matrice $\mathbf{A_b}$, soit $2N \times 2N$. Dans la suite, les symboles primés sont relatifs à la configuration en champ proche et ceux non primés à la configuration en champ lointain. Avec cette convention, la matrice $\mathbf{A'_b}$ peut se décomposer de manière similaire à (7) :

$$\mathbf{A'_b} = \sum_{k=1}^{2N} \lambda'_k \mathbf{V'_k} \quad \text{avec} \quad \mathbf{V'_k} = \mathbf{U'I_k V'^H} \qquad\qquad (13)$$

Si l'on définit le vecteur $\mathbf{a'_b}$ de taille $4N^2$ comme la concaténation des $2N$ vecteurs colonne de la matrice $\mathbf{A'_b}$ et, de manière similaire, le vecteur $\mathbf{v'_k}$ comme la concaténation des vecteurs colonne de la matrice $\mathbf{V'_k}$, la relation (7) s'écrit de manière vectorielle :

$$\mathbf{a'_b} = \sum_{k=1}^{2N} \lambda'_k \mathbf{v'_k} = \mathbf{V'\lambda'} \qquad\qquad (14)$$

dans laquelle $\lambda'$ est un vecteur ayant pour composantes les valeurs modales $\lambda'_k$, $k=1,...,2N$, et $\mathbf{V'}$ est la matrice de taille $2N \times 2N$ dont les colonnes sont constituées par les vecteurs $\mathbf{v'_k}$. Chacun des vecteurs $\mathbf{v'_k}$ correspond à l'excitation d'un courant caractéristique de la cible lorsqu'elle est illuminée dans la configuration en champ proche à une distance correspondant à la longueur de base. Dans la suite, les vecteurs $\mathbf{v'_k}$ sont également dénommés vecteurs modaux en champ proche.

De même que pour la configuration en champ lointain, on effectue la sélection des *s* modes les plus énergétiques :

$$\tilde{\mathbf{a}}'_{\mathbf{b}} = \sum_{k \in S} \lambda'_k \mathbf{v}'_k \qquad (15)$$

où *s* = *Card*(*S*). On notera que l'on sélectionne le même nombre de modes en champ proche qu'en champ lointain. Cette sélection revient à réduire corrélativement la dimensionnalité de λ' et de **V':**

$$\tilde{\mathbf{a}}'_{\mathbf{b}} = \mathbf{V}'^{\mathbf{s}} \lambda'^{\mathbf{s}} \qquad (16)$$

où le vecteur λ'**ˢ** est obtenu en éliminant de λ' les composantes non sélectionnées et, de même, la matrice **V'ˢ** est obtenue à partir de **V'** en supprimant les vecteurs colonne non sélectionnés. **V'ˢ** est donc une matrice de taille $4N^2 \times s$.

Les bases modales en champ lointain ($\mathbf{v_k}$, $k \in S$) et en champ proche ($\mathbf{v'_k}$, $k \in S$) étant obtenues, on cherche à associer à chaque vecteur modal en champ lointain un vecteur modal correspondant en champ proche. Cette correspondance peut par exemple être déterminée en recherchant pour chaque vecteur modal $\mathbf{v_k}$, $k \in S$ le vecteur modal $v'_{f(k)}$ tel que la distance $\|\mathbf{v_k} - v'_{f(k)}\|$ est minimale, où *f* est une bijection (c'est-à-dire une permutation) sur *S*. Selon une variante avantageuse, la correspondance est établie de proche en proche en faisant varier la longueur de base de la valeur réelle (utilisée pour la mesure) à une valeur sensiblement supérieure à la distance de Rayleigh. Un calcul des vecteurs modaux $\mathbf{v'_k}$, $k \in S$ est fait à chaque étape et la bijection *f* est simplement la composée de bijections intermédiaires $f_1 \circ f_2 \circ ... f_L$.

Cette bijection étant identifiée, on fera abstraction dans les notations de la permutation *f* pour des raisons de simplification. Autrement dit, l'indice *s* désigne dans la suite des modes correspondants en champ lointain et en champ proche.

On détermine ensuite un opérateur *F* transformant le vecteur λ'**ˢ** en vecteur λ**ˢ,** autrement dit transformant les valeurs modales en champ proche en valeurs modales en champ lointain.

Cet opérateur peut être obtenu de différentes manières. Selon une première variante, l'opérateur *F* est simplement représenté par la matrice diagonale :

$$\mathbf{F} = \mathbf{Diag}\left(\lambda_s / \lambda'_s\right) \qquad (17)$$

Alternativement, si une pluralité *P* de simulations est réalisée, chaque simulation fournissant un couple de vecteur modaux $\lambda'^{s}_{p}$ et $\lambda^{s}_{p}$, l'opérateur *F* pourra être déterminé comme la matrice pseudo-inverse **F†** minimisant la distance entre $F(\lambda'^s)$ et λ^s sur l'ensemble des couples $\lambda'^{s}_{p}$, $\lambda^{s}_{p}$, *p*=1,...,*P*. D'autres versions de l'opérateur peuvent être envisagées sans sortir du cadre de la présente invention.

En tout état de cause, les mesures en champ proche sont ensuite effectuées sur la cible réelle.

On note **a''ᵘ** le vecteur des rapports des amplitudes complexes de l'onde diffractée et de l'onde incidente, telles que mesurées. Ce vecteur est généralement très lacunaire par rapport à $\tilde{\mathbf{a}}'_b$ : seules certaines directions et certaines polarisations auront généralement fait l'objet d'une mesure. Par exemple les éléments correspondants à la configuration monostatique pourront être manquants. On note $N^\mu$ le nombre de mesures, avec $N^\mu \ll 4N^2$ mais $N^\mu \geq s$, et **V'ᵘ** la matrice obtenue à partir de **V'ˢ** en éliminant les lignes pour lesquelles une mesure n'est pas disponible. **a'ᵘ** est donc un vecteur de taille $N^\mu$ et **V'ᵘ** une matrice de taille $N^\mu \times s$.

Selon le principe de l'invention, le vecteur **a'ᵘ** est projeté sur l'espace propre $E'^s$ engendré par les vecteurs modaux $v'_k$, $k \in S$ ce qui revient à calculer le vecteur :

$$\lambda'^{\mu} = \left(\mathbf{V}'^{\mu}\right)^{\dagger} \mathbf{a}'^{\mu} \qquad (18)$$

où l'on a noté $(\mathbf{v'^{\mu}})^{\dagger} = (\mathbf{v'^{\mu H}V'^{\mu}})^{-1}\mathbf{V'^{\mu H}}$ la matrice pseudo-inverse de $\mathbf{V'''}$ et $\mathbf{V'^{\mu H}}$ la transposée conjuguée de $\mathbf{V'^{\mu}}$. La matrice pseudo-inverse peut être obtenue par exemple, au moyen d'une décomposition en valeurs singulières de $\mathbf{V'^{\mu}}$. L'écart entre les $2N$ composantes de $\lambda'^{\mu}$ et les composantes modales théoriques est dû, d'une part au bruit de mesure au sens large (échos parasites, couplages, bruit au niveau de l'instrumentation etc.) et d'autre part aux différences entre le modèle et l'objet réel mesuré. On comprendra que seul le bruit de mesure projeté sur l'espace $E'^s$ affecte cet écart. La projection sur $E'^s$ peut être considérée comme un filtrage adapté au modèle de diffraction de l'objet, permettant d'augmenter le rapport signal à bruit des mesures effectuées.

On détermine ensuite les composantes modales correspondantes en champ lointain au moyen de l'opérateur $F$, soit :

$$\lambda^{\mu} = F\left(\lambda'^{\mu}\right) \tag{19}$$

Si l'on définit maintenant un vecteur reconstruit, $\tilde{\mathbf{a}}$, par:

$$\tilde{\mathbf{a}} = \mathbf{V}^s\lambda^{\mu} \tag{20}$$

$\tilde{\mathbf{a}}$ est un vecteur de taille $4N^2$ qui correspond à une matrice $\tilde{\mathbf{A}} = \left(\tilde{a}_{ij}^{\pi_e,\pi_r}\right)$, $i,j=1,..,N$ de taille $2N{\times}2N$ dont les vecteurs colonne sont respectivement les $2N$ blocs de $2N$ composantes successives de $\tilde{\mathbf{a}}$. En d'autres termes la matrice $\tilde{\mathbf{A}}$ est obtenue à partir de $\tilde{\mathbf{a}}$, de la même façon que $\mathbf{A_b}$ s'obtient à partir de $\mathbf{a_b}$.

On définit enfin la SER $\tilde{\Sigma}$ par ses composantes $\tilde{\sigma}_{ij}^{\pi_e\pi_r} = \left|\tilde{a}_{ij}^{\pi_e\pi_r}\right|^2$, $i, j = 1,..,2N$, $\pi_c = H$ ou $V$, $\pi_r = H$ ou $V$.

La méthode exposée plus haut peut éventuellement être itérée, la matrice $\tilde{\mathbf{A}}$ servant alors de nouveau modèle $\mathbf{A_b}$. On corrige ainsi le modèle au fur et à mesure des itérations pour le rendre plus conforme à l'objet réellement mesuré.

La séquence des opérations de filtrage, changement de base au moyen de $F$ et reconstruction, faisant correspondre $\mathbf{a}^{\mu}$ à $\tilde{\mathbf{a}}$ présente un intérêt multiple :

Tout d'abord, elle permet de passer de mesures en champ proche à des valeurs de SER, conformément à l'objet de l'invention.

Elle permet en outre d'obtenir des valeurs de SER $\left(\tilde{\sigma}_{ij}^{\pi_e\pi_r}\right)$ pour des couples de directions $(\vec{u}_e,\vec{u}_r)$ et/ou des couples de polarisations $(\pi_e,\pi_r)$ non mesurées. Ainsi, à partir d'un nombre relativement faible de mesures, on obtient grâce à cette extrapolation une estimation de la SER bistatique complète $\tilde{\Sigma}$ de l'objet. Ceci est dû au fait que les vecteurs $\mathbf{v_k}$, $k \in S$ forment une base adaptée à la détermination de la SER.

D'autre part, même pour un couple de directions $(\vec{u}_e,\vec{u}_r)$ et un couple de polarisations $(\pi_e,\pi_r)$ ayant fait l'objet d'une mesure, la SER $\tilde{\sigma}_{ij}^{\pi_e\pi_r}$ sera meilleure que celle qui aurait été obtenue directement à partir de la mesure. Ceci est dû au filtrage de bruit par projection sur l'espace $E'^s$, comme expliqué précédemment.

Enfin, elle permet d'obtenir une meilleure estimation de la SER que celle donnée initialement par le modèle de diffraction. En effet le modèle donne approximativement les axes propres de la SER et les mesures permettent d'estimer précisément les composantes modales sur les axes en question.

La précision avec laquelle on pourra estimer les composantes modales et, par conséquent la SER, dépend en grande partie du conditionnement de la matrice $\mathbf{V'^{\mu}}$ dans (18). On rappelle que le nombre de conditionnement d'une matrice carrée $\Omega$ inversible est donnée par :

$$cond\left(\mathbf{\Omega}\right) = \left\|\mathbf{\Omega}^{-1}\right\|.\left\|\mathbf{\Omega}\right\| \tag{21}$$

où l'on a noté $\|.\|$ la norme euclidienne.

Le mauvais conditionnement de la matrice $\mathbf{V'^{\mu}}$ peut être dû soit à un nombre de modes sélectionnés s trop élevé, les vecteurs $\mathbf{v'_k}$, $k \in S$ étant alors quasiment liés, soit à un nombre de mesures $N^{\mu}$ insuffisant.

On pourra alors réduire le nombre $s$ de modes sélectionnés, en décimant les vecteurs colonnes de $\mathbf{V'^{\mu}}$ (et corrélativement de $\mathbf{V^{\mu}}$) en éliminant de préférence les modes les moins énergétiques, le cas échéant de manière itérative, jusqu' à ce que :

$$cond\left( \mathbf{V}^{\prime\mu H} \mathbf{V}^{\prime\mu} \right) < cond_T \qquad\qquad (22)$$

où $cond_T$ est une valeur de seuil prédéterminée.

Alternativement, on augmentera le nombre de mesures, le cas échéant de manière itérative, jusqu'à ce que le conditionnement soit satisfaisant.

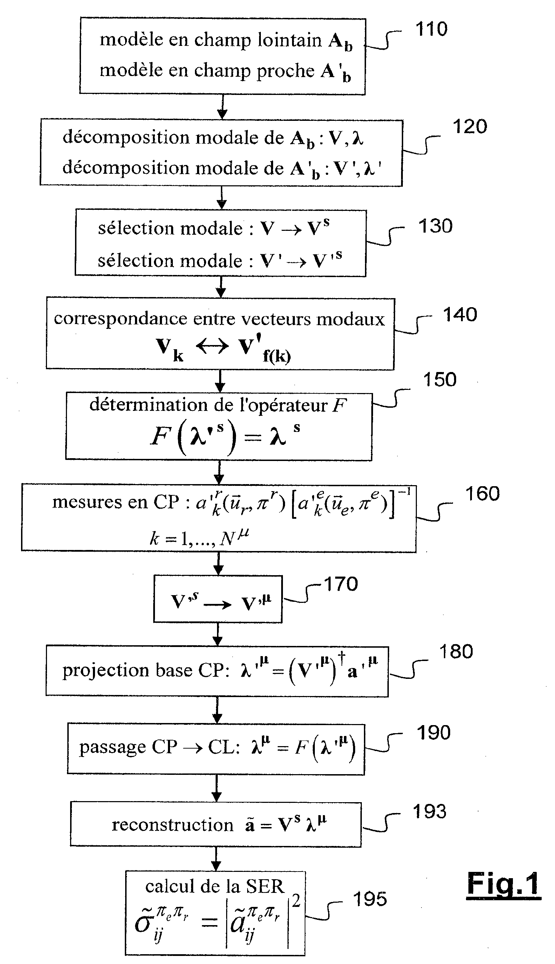

La Fig. 1 illustre de manière schématique le procédé d'estimation de SER selon un mode de réalisation de l'invention.

Le procédé part en 110 d'un modèle de diffraction en champ lointain et d'un modèle de diffraction en champ proche de l'objet dont on souhaite estimer la SER.

Le modèle en champ lointain est défini par une matrice de diffraction $\mathbf{A_b}$ pour une pluralité de couples d' ondes incidentes et d' ondes diffractées ainsi qu' une pluralité de polarisations. Dans ce modèle, les ondes incidentes et diffractées sont considérées comme planes.

Le modèle en champ proche est défini par une matrice de diffraction $\mathbf{A'_b}$ obtenue également pour une pluralité de couples d'ondes incidentes et d'ondes diffractées ainsi qu'une pluralité de polarisations. Dans ce modèle, les ondes incidentes et/ou diffractées sont considérées comme émises et/ou reçues en champ proche c'est-à-dire à une distance inférieure à la distance de Rayleigh de l'objet.

A l'étape 120, on procède à la décomposition modale de $\mathbf{A_b}$. On obtient la matrice des vecteurs propres $\mathbf{V}$ et le vecteur des valeurs modales $\lambda$. On procède de la même façon à la décomposition modale de $\mathbf{A'_b}$. On obtient la matrice des vecteurs propres $\mathbf{V'}$ et le vecteur des valeurs modales $\lambda'$.

A l'étape 130, on détermine l'ensemble $S$ des modes les plus significatifs et l'on réduit par suppression de colonnes la matrice $\mathbf{V}$ en la matrice $\mathbf{V}^s$ dans laquelle seuls les modes de $S$ sont conservés. On procède de même pour la matrice $\mathbf{V}$ en gardant le même nombre $s=Card(S)$ de modes les plus significatifs, on obtient alors la matrice $\mathbf{V'}^s$. Il est à noter que les colonnes supprimées dans $\mathbf{V'}^s$ ne sont pas nécessairement les mêmes que celles supprimées dans $\mathbf{V}^s$.

A l'étape 140, on établit une correspondance entre les vecteurs modaux en champ lointain et les vecteur modaux en champ proche, soit directement soit par l'intermédiaire de plusieurs étapes d'association successives utilisant des bases modales en champ proche pour des longueurs de bases distribuées entre la longueur de base réelle (utilisée pour les mesures) et l'infini, avantageusement entre la longueur de base réelle et la distance de Rayleigh.

A l'étape 150, on détermine l'opérateur $F$ permettant de passer des valeurs modales en champ proche aux valeurs modales en champ lointain. Plus précisément, l'opérateur $F$ permet de passer de chaque valeur modale, relative à un vecteur modal en champ proche, à la valeur modale relative au vecteur modal en champ lointain correspondant, au sens de l'étape précédente.

A l'étape 160, on effectue $N^\mu > Card(S)$ mesures d'amplitudes complexes d'onde incidente $a'^e_k(\vec{u}_e, \pi^e)$ et d'onde diffractée $a'^r_k(\vec{u}_r, \pi^r)$, en champ proche, pour obtenir les $N^\mu$ rapports complexes $a'^r_k(\vec{u}_r, \pi^r)\left[ a'^e_k(\vec{u}_e, \pi^e) \right]^{-1}$ donnant les composantes de $\mathbf{a'}^\mu$.

A l'étape 170, on élimine de $\mathbf{V'}^s$ les $4N^2 - N^\mu$ lignes non concernées par la mesure pour obtenir $\mathbf{V'}^\mu$.

On projette en 180 le vecteur $\mathbf{a'}^\mu$ sur l'espace $E'^s$, pour obtenir les composantes modales en champ proche, soit $\lambda'^\mu = (\mathbf{v'}^\mu)^\dagger \mathbf{a'}^\mu$.

On utilise ensuite en 190 l'opérateur $F$ pour passer des composantes modales de la mesure en champ proche aux composantes modales en champ lointain, soit $\lambda^\mu = F(\lambda'^\mu)$.

On calcule ensuite en 193, le vecteur reconstruit $\tilde{\mathbf{a}} = \mathbf{V}^s \lambda^\mu$.

En 195, la SER bistatique complète $\tilde{\Sigma}$ est obtenue à partir de $\tilde{\mathbf{a}}$ : $\tilde{\sigma}_{ij}^{\pi_e \pi_r} = \left| \tilde{a}_{ij}^{\pi_e \pi_r} \right|^2$. On peut également se contenter du calcul de certains éléments de la matrice, par exemple ceux donnant la SER monostatique, voire d'un seul pour un couple de directions et un couple de polarisations désirés.

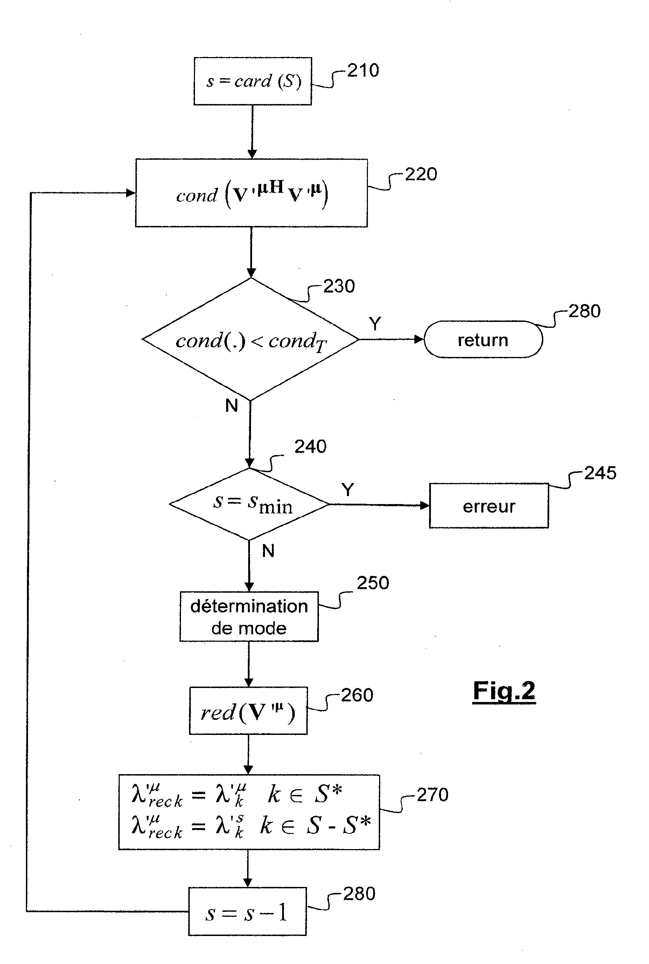

Le procédé d'estimation comprend avantageusement mais non nécessairement une étape de reconditionnement de la matrice $\mathbf{V'}^\mu$. Cette étape de reconditionnement matriciel est détaillée en Figs. 2 à 4.

La Fig. 2 en représente une première variante.

A l'étape 210, on initialise à $card(S)$ le compteur de modes $s$.

A l'étape 220, le nombre de conditionnement de la matrice $\mathbf{V'}^{\mu H} \mathbf{V'}^\mu$ est calculé puis l'on teste en 230 si ce nombre est inférieur à une valeur de seuil $cond_T$. Dans l'affirmative, on sort en 280.

En revanche, dans la négative, on teste en 240 si $s$ est égal au nombre minimum de modes calculés, $s_{min}$ -

Si c'est le cas, on termine en retournant un message d'erreur en 245. Dans le cas contraire, on détermine en 250 le mode le moins significatif, c'est-à-dire la composante $k$ de $\lambda'^s$ de plus faible module.

En 260, on élimine de $\mathbf{V'}^\mu$ le $k^{ème}$ vecteur colonne correspondant à cette composante.

En 270, on substitue dans le vecteur λ'**ᵘ** la $k^{i\text{ème}}$ composante par celle de λ'**ˢ,** on décrémente $s$ en 280 puis on retourne à l'étape 220.

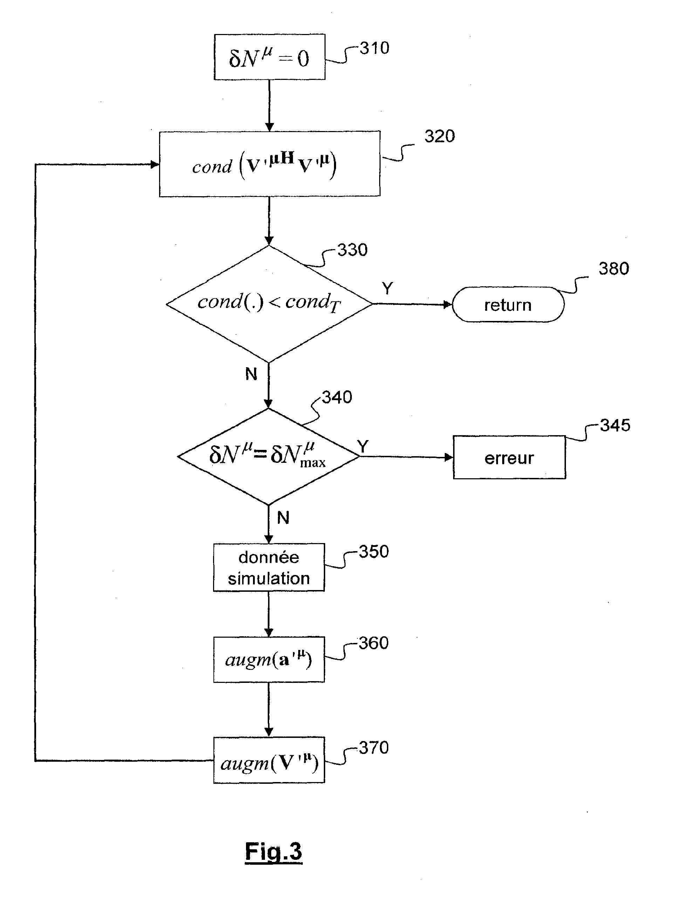

On a représenté en Fig. 3 une seconde variante du procédé de reconditionnement matriciel.

A l'étape 310, on initialise à zéro le compteur de données de simulation, $\delta N^\mu$.

A l'étape 320, le nombre de conditionnement de la matrice **V'ᵘᴴV'ᵘ** est calculé puis l'on teste en 330 si ce nombre est inférieur à une valeur de seuil $cond_T$. Dans l'affirmative, on sort en 380.

En revanche, dans la négative, on teste en 340 si $\delta N^\mu$ est égal au nombre maximum de données de simulation $\delta N^\mu_{\max}$ .

Si c'est le cas, on termine en retournant un message d'erreur en 345. Dans le cas contraire, on choisit en 350 une donnée de simulation disponible.

En 360, on ajoute à **a'ᵘ** une composante supplémentaire égale à la donnée de simulation puis l'on recalcule **V'ᵘ** en 370.

On retourne ensuite à l'étape 320 pour le calcul du nouveau nombre de conditionnement.

On comprendra que le choix de la donnée de simulation pourra être fait en fonction du gain de conditionnement obtenu. On comprendra également, comme déjà exposé plus haut, qu'un reconditionnement matriciel selon la seconde variante peut faire suite à un reconditionnement matriciel selon la première variante. Alternativement, on fera appel tour à tour à l'un et à l'autre.

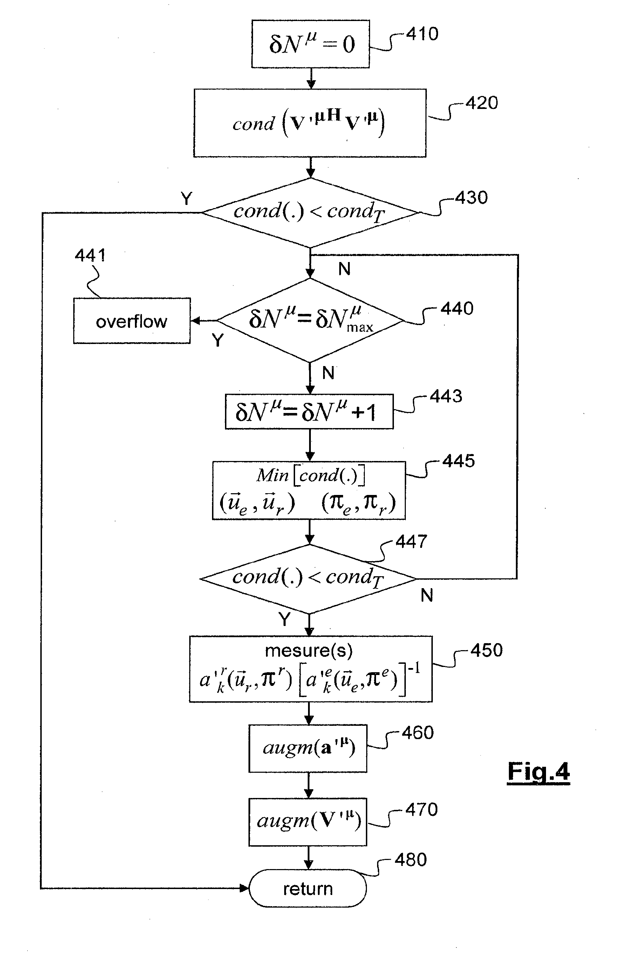

La Fig. 4 représente une troisième variante du procédé de reconditionnement matriciel.

A l'étape 410, on initialise à zéro le compteur de mesures additionnelles, $\delta N^\mu$.

A l'étape 420, le nombre de conditionnement de la matrice **VᵘᴴVᵘ** est calculé puis l'on teste en 430 si ce nombre est inférieur à une valeur de seuil $cond_T$. Dans l'affirmative, on sort en 480.

En revanche, dans la négative, on teste si l'on a atteint un nombre maximal de mesures additionnelles $\dot{\delta} N^\mu_{\max}$ . Si c'est le cas on retourne un message d'overflow en 441.

Dans la négative, on incrémente $N^\mu$ et $\delta N^\mu$ en 443. On détermine en 445 à partir de **V'ˢ** parmi les $4N^2$ -$N^\mu$ combinaisons de directions $(\vec{u}_e, \vec{u}_r)$ et polarisations $(\pi_e, \pi_r)$ possibles, celle susceptible de minimiser le nombre de conditionnement.

Les étapes 443 et 445 sont répétées tant que le nombre de conditionnement est supérieur à la valeur de seuil $cond_T$, comme testé en 447.

En 450, on effectue la ou les mesure (s) additionnelle(s) dans les conditions précitées et on calcule le(s) rapport(s) complexe(s) $a''^r_k(\vec{u}_r, \pi^r)\left[ a''^e_k(\vec{u}_e, \pi^e) \right]^{-1}$ .

On rajoute en 450 à **a'ᵘ** la(les) composante(s) supplémentaire(s) égale(s) à ce(s) rapport(s) complexe(s), et, en 460, la(les) ligne(s) correspondante(s) à **V'ᵘ.** Le procédé de reconditionnement matriciel se termine en 480.

## Revendications

1. Méthode d'estimation de surface équivalente radar d'un objet donné à partir d'un premier modèle de diffraction en champ lointain dudit objet et d'un second modèle de diffraction en champ proche dudit objet (110), les premier et second modèles pouvant être respectivement représentés par une première matrice **(A_b)** et une seconde matrice **(A'_b)** de rapports d'amplitudes complexes d'onde diffractée et d'onde incidente, pour une pluralité $(4N^2)$ de couples de directions et de polarisations respectives de l'onde incidente et d'observation de l'onde diffractée, dans laquelle :

   - on effectue une décomposition modale (120) desdites première et seconde matrices et l'on sélectionne (130) les vecteurs modaux **(V,V')** les plus significatifs de la première et de la seconde matrices ainsi décomposées pour obtenir une première base et une seconde base de vecteurs modaux ;
   - on établit (140) une correspondance entre vecteurs modaux de la première base et vecteurs modaux de la seconde base ;
   - on détermine (150) un opérateur ($F$) permettant de passer des secondes valeurs modales (λ'**ˢ**) associées aux vecteurs modaux de la seconde base aux premières valeurs modales (λ**ˢ)** associées aux vecteurs modaux correspondants de la première base ;
   - on effectue (160) une pluralité ($N^\mu$) de mesures de rapports d'amplitudes complexes d'onde diffractée et d'onde incidente en champ proche pour une pluralité de couples de directions et au moins un couple de polarisations respectives de l'onde incidente et d'observation de l'onde diffractée ;
   - on projette (180) le vecteur **(a'ᵘ),** formé par les rapports ainsi mesurés, sur lesdits vecteurs modaux de la seconde base, pour obtenir des secondes composantes modales ($\lambda'^\mu$) sur cette base ;
- on obtient (190) des premières composantes modales ($\lambda^\mu$) sur la première base modale en appliquant ledit opérateur aux secondes composantes modales ;
- on génère (193) à partir des premières composantes modales et des vecteurs modaux de la première base un vecteur reconstruit ($\tilde{\mathbf{a}}$) dont les composantes sont représentatives des rapports d'amplitudes complexes d'onde incidente et diffractée pour ladite pluralité de couples de directions et de polarisations ;
- on détermine (195) la surface équivalente radar à partir d'au moins une composante du vecteur reconstruit.

2.  Méthode d'estimation selon la revendication 1, **caractérisée en ce que** ladite décomposition modale est une diagonalisation et que :

    - les vecteurs modaux de la première base et les premières valeurs modales sont respectivement les vecteurs propres et les valeurs propres de la première matrice ;
    - les vecteurs modaux de la seconde base et les secondes valeurs modales sont respectivement les vecteurs propres et les valeurs propres de la seconde matrice.

3.  Méthode d'estimation selon la revendication 1, **caractérisé en ce que** ladite décomposition modale est une décomposition en valeurs singulières et que :

    - les vecteurs modaux de la première base et les premières valeurs modales sont respectivement les vecteurs singuliers et les valeurs singulières de la première matrice ;
    - les vecteurs modaux de la seconde base et les secondes valeurs modales sont respectivement les vecteurs singuliers et les valeurs singulières de la seconde matrice.

4.  Méthode d'estimation selon la revendication 1, **caractérisée en ce que** ladite correspondance est établie en recherchant pour chaque vecteur modal de la seconde base, le vecteur modal de la première base qui lui est le plus proche.

5.  Méthode d'estimation selon la revendication 1, **caractérisée en ce que** ladite correspondance est établie de proche en proche entre les vecteurs modaux de la première base et les vecteurs modaux de la seconde base, au moyen d'une pluralité d'opérations successives, chaque association étant relative à une base de vecteurs modaux intermédiaire.

6.  Méthode d'estimation selon les revendications 1 à 5, **caractérisée en ce que** ledit opérateur est défini par $\mathbf{F=Diag}(\lambda_s/\lambda'_s)$ où $\lambda_s,\lambda'_s$ sont respectivement les premières et secondes valeurs modales et **Diag(.)** est la matrice diagonale de rang $s$, égal au nombre de vecteurs modaux de la première/ seconde base.

7.  Méthode d'estimation selon les revendications 1 à 5, **caractérisée en ce que** ledit opérateur est défini par une matrice pseudo-inverse minimisant la distance entre $F(\lambda'^s)$ et $\lambda^s$ pour un ensemble de couples $\lambda_p'^s$ , $\lambda_p^s$ ,$p=1,...,P,$ où $\lambda_p^s$ et $\lambda_p'^s$ sont des premières et secondes valeurs modales obtenues par P simulations respectives du premier et du second modèles de diffraction.

8.  Méthode d'estimation selon l'une des revendications précédentes, **caractérisée en ce que** les secondes composantes modales sont déterminées par :

$$\lambda'^\mu = \left( \mathbf{V}'^\mu \right)^\dagger \mathbf{a}'^\mu$$

où $\lambda'^\mu$ représente le vecteur des secondes composantes modales, $(V'^\mu)^+$ est la matrice pseudo-inverse de $V'^\mu$, $V'^\mu$ est la matrice dont les colonnes sont lesdits vecteurs modaux de la seconde base et dont les lignes correspondent à la seconde pluralité de rapports mesurés.

9.  Méthode d'estimation selon la revendication 8, **caractérisée en ce que** l'on génère le vecteur reconstruit, $\tilde{a}$, par :

$$\widetilde{\mathbf{a}} = \mathbf{V^s}\boldsymbol{\lambda}^{\boldsymbol{\mu}}$$

où **V$^s$** est la matrice dont les colonnes sont lesdits vecteurs modaux de la première base et dont les lignes correspondent à la première pluralité de rapports du premier modèle.

10. Méthode d'estimation selon la revendication 9, **caractérisée en ce que** la surface équivalente radar $\left(\widetilde{\sigma}_{ij}^{\pi_e \pi_r}\right)$ pour un couple de directions d'onde incidente et d'observation d'onde diffractée et un couple de polarisations associées est obtenue à partir du module au carré $\left(\left|\widetilde{a}_{ij}^{\pi_e \pi_r}\right|^2\right)$ d'une composante dudit vecteur reconstruit.

11. Méthode d'estimation selon l'une des revendications 8 à 10, **caractérisée en ce que** la matrice pseudo-inverse de **V'$^\mu$** est obtenue par **(V'$^\mu$)$^\dagger$=('$^{\mu H}$V'$^\mu$)$^{-1}$V'$^{\mu H}$** et que la matrice **V'$^\mu$** fait préalablement l'objet d'un reconditionnement matriciel si le nombre de conditionnement de la matrice **V'$^{\mu H}$ V'$^\mu$** est supérieur à un seuil prédéterminé (*cond$_T$*).

12. Programme d'ordinateur comprenant des moyens logiciels adaptés à mettre en oeuvre les étapes de la méthode d'estimation selon l'une des revendications précédentes, lorsqu'il est exécuté par un ordinateur.

## Patentansprüche

1. Verfahren zur Abschätzung der äquivalenten Radaroberfläche eines gegebenen Objekts ausgehend von einem ersten Beugungsmodell im Fernfeld des Objekts und von einem zweiten Beugungsmodell im Nahfeld des Objekts (110), wobei das erste und das zweite Modell dargestellt werden können durch eine erste Matrix **(A$_b$)** bzw. eine zweite Matrix **(A'$_b$)** von Verhältnissen der komplexen Amplituden einer gebeugten Welle und einer einfallenden Welle für eine Mehrzahl (4N$^2$) von Paaren von Richtungen und jeweiligen Polarisationen der einfallenden Welle und der Beobachtung der gebeugten Welle, wobei:

- man eine modale Zerlegung (120) der ersten und der zweiten Matrix durchführt und man die signifikantesten modalen Vektoren **(V, V')** der derart zerlegten ersten und zweiten Matrix auswählt (130), um eine erste Basis und eine zweite Basis von modalen Vektoren zu erhalten;
- man eine Korrespondenz zwischen modalen Vektoren der ersten Basis und modalen Vektoren der zweiten Basis erstellt (140);
- man einen Operator (F) bestimmt (150), der er ermöglicht, zweite modale Werte **($\lambda$'$^s$),** die den modalen Vektoren der zweiten Basis zugeordnet sind, in erste modale Werte **($\lambda^s$)** zu überführen, die den entprechenden modalen Vektoren der ersten Basis zugeordnet sind;
- man eine Mehrzahl (N$^\mu$) von Messungen von Verhältnissen komplexer Amplituden von gebeugter Welle und von einfallender Welle im Nahfeld für eine Mehrzahl von Paaren von Richtungen und wenigstens ein Paar von jeweiligen Polarisationen der einfallenden Welle und der Beobachtung der gebeugten Welle durchführt (160);
- man den Vektor **(a'$^\mu$),** der durch die derart gemessenen Verhältnisse gebildet ist, auf die modalen Vektoren der zweiten Basis projiziert (180), um zweite modale Komponenten **($\lambda$'$^\mu$)** auf dieser Basis zu erhalten;
- man erste modale Komponenten **($\lambda^\mu$)** auf der ersten modalen Basis erhält (190), indem man den Operator auf die zweiten modalen Komponenten anwendet;
- man ausgehend von den ersten modalen Komponenten und den modalen Vektoren der ersten Basis einen rekonstruierten Vektor (ä) generiert (193), dessen Komponenten repräsentativ sind für die Verhältnisse der komplexen Amplituden von einfallender und gebeugter Welle für die Mehrzahl von Paaren von Richtungen und Polarisationen;
- man die äquivalente Radaroberfläche ausgehend von wenigstens einer Komponente des rekonstruierten Vektors bestimmt (195).

2. Verfahren zur Abschätzung nach Anspruch 1, **dadurch gekennzeichnet, dass** die modale Zerlegung eine Diagonalisierung ist, und dass:

- die modalen Vektoren der ersten Basis und die ersten modalen Werte die Eigenvektoren bzw. die Eigenwerte der ersten Matrix sind;

- die modalen Vektoren der zweiten Basis und die zweiten modalen Werte die Eigenvektoren bzw. die Eigenwerte der zweiten Matrix sind.

3. Verfahren zur Abschätzung nach Anspruch 1, **dadurch gekennzeichnet, dass** die modale Zerlegung eine Zerlegung in singuläre Werte ist, und dass:

   - die modalen Vektoren der ersten Basis und die ersten modalen Werte die singulären Vektoren bzw. die singulären Werte der ersten Matrix sind;
   - die modalen Vektoren der zweiten Basis und die zweiten modalen Werte die singulären Vektoren bzw. die singulären Werte der zweiten Matrix sind.

4. Verfahren zur Abschätzung nach Anspruch 1, **dadurch gekennzeichnet, dass** die Korrespondenz erstellt wird, indem man für jeden modalen Vektor der zweiten Basis denjenigen modalen Vektor der ersten Basis sucht, der ihm am nächsten ist.

5. Verfahren zur Abschätzung nach Anspruch 1, **dadurch gekennzeichnet, dass** die Korrespondenz nach und nach zwischen den modalen Vektoren der ersten Basis und den modalen Vektoren der zweiten Basis mit Hilfe einer Mehrzahl aufeinanderfolgender Operationen erstellt wird, wobei jede Zuordnung relativ zu einer Zwischenbasis von modalen Vektoren ist.

6. Verfahren zur Abschätzung nach den Ansprüchen 1 bis 5, **dadurch gekennzeichnet, dass** der Operator definiert ist durch **F = Diag** $(\lambda_s / \lambda'_s)$, wobei $\lambda_s$, $\lambda'_s$ der erste bzw. der zweite modale Wert sind, und wobei **Diag(.)** die Diagonalmatrix vom Rang s gleich der Zahl von modalen Vektoren der ersten/zweiten Basis ist.

7. Verfahren zur Abschätzung nach den Ansprüchen 1 bis 5, **dadurch gekennzeichnet, dass** der Operator durch eine pseudo-inverse Matrix definiert ist, die den Abstand minimiert zwischen F $(\lambda\mathbf{'^s})$ und $\lambda\mathbf{^s}$ für eine Gruppe von Paaren $\lambda\mathbf{p'^s}$, $\lambda\mathbf{p^s}$, p = 1, ..., P, wobei $\lambda\mathbf{p^s}$ und $\lambda\mathbf{p'^s}$ erste und zweite modale Werte sind, die durch P jeweilige Simulationen des ersten und des zweiten Beugungsmodells erhalten werden.

8. Verfahren zur Abschätzung nach einem der vorhergehenden Ansprüche, **dadurch gekennzeichnet, dass** die zweiten modalen Komponenten bestimmt sind durch:

$$\lambda^{'\mu} = (V^{'\mu})^{\dagger} \, a^{'\mu}$$

wobei $\lambda^{'\mu}$ den Vektor der zweiten modalen Komponenten darstellt, $(V'^{\mu})^{\dagger}$ die pseudo-inverse Matrix von $V'^{\mu}$ ist, $V'^{\mu}$ die Matrix ist, deren Spalten die modalen Vektoren der zweiten Basis sind, und deren Zeilen der zweiten Mehrzahl von gemessenen Verhältnissen entsprechen.

9. Verfahren zur Abschätzung nach Anspruch 8, **dadurch gekennzeichnet, dass** man den rekonstruierten Vektor $\tilde{a}$ generiert durch:

$$\tilde{a} = V^s \lambda^{\mu}$$

wobei $V^s$ die Matrix ist, deren Spalten die modalen Vektoren der ersten Basis sind, und deren Zeilen der ersten Mehrzahl von Verhältnissen des ersten Modells entsprechen.

10. Verfahren zur Abschätzung nach Anspruch 9, **dadurch gekennzeichnet, dass** die äquivalente Radaroberfläche $(\tilde{\sigma}_{ij}^{\pi_e, \pi_r})$ für ein Paar von Richtungen der einfallenden Welle und der Beobachtung der gebeugten Welle und ein Paar von zugeordneten Polarisationen erhalten wird ausgehend vom Betragsquadrat $(\left| \tilde{a}_{ij}^{\pi_e, \pi_r} \right|^2)$ einer Komponente des rekonstruierten Vektors.

11. Verfahren zur Abschätzung nach einem der Ansprüche 8 bis 10, **dadurch gekennzeichnet, dass** die pseudo-

inverse Matrix von $\mathbf{V'^{\mu}}$ erhalten wird durch $\mathbf{(V'^{\mu})^{\dagger}} = \mathbf{(V'^{\mu H}\ V'^{\mu})^{-1}\ V'^{\mu H}}$, und dass die Matrix $\mathbf{V'^{\mu}}$ zuvor Gegenstand einer Matrixrekonditionierung ist, wenn die Konditionszahl der Matrix $\mathbf{V'^{\mu H}\ V'^{\mu}}$ größer als eine vorbestimmte Schwelle $(\text{cond}_T)$ ist.

12. Computerprogramm, umfassend Softwaremittel, die dazu ausgelegt sind, die Schritte des Verfahrens zur Abschätzung nach einem der vorhergehenden Ansprüche durchzuführen, wenn es von einem Computer ausgeführt wird.


**Claims**

1. Method for estimating the equivalent radar cross section on the basis of a first near-field diffraction model of said object and a second near-field diffraction model of said object, the first and second models being able to be respectively represented by a first matrix $(\mathbf{A_b})$ and a second matrix $(\mathbf{A'_b})$ of complex diffracted wave and incident wave amplitude ratios, for a plurality $(4N^2)$ of pairs of respective directions and polarisations of the incident wave and observation of the diffracted wave, in which:

   - a modal decomposition of said first and second matrices is carried out and the most significant modal vectors $(\mathbf{V, V'})$ of the first and second matrices thus decomposed are selected (130) in order to obtain a first base and a second base of modal vectors;
   - a correspondence is established (140) between modal vectors of the first base and modal vectors of the second base;
   - an operator $(F)$ for passing from the second modal vectors $(\lambda'^s)$ associated with the modal vectors of the second base to the first modal values $(\lambda^s)$ associated with the modal vectors corresponding to the first base is determined (150);
   - a plurality $(N^{\mu})$ of measurements of complex diffracted wave and incident wave amplitude ratios in near field are made (160) for a plurality of pairs of directions and at least one pair of respective polarisations of the incident wave and observation of the diffracted wave;
   - the vector $(\mathbf{a'})$, formed by the ratios thus measured, is projected (180) onto said modal vectors of the second base, in order to obtain second modal components $(\lambda'^{\mu})$ on this base;
   - first modal components $(\lambda^{\mu})$ on the first modal base are obtained (190) by applying said operator to the second modal components;
   - from the first modal components and the modal vectors of the first base a reconstructed vector $(\tilde{\mathbf{a}})$ is generated (193), the components of which represent the complex incident wave and diffracted wave amplitude ratios for said plurality of pairs of directions and polarisations;
   - the equivalent radar cross section is determined (195) from at least one component of the reconstructed vector.

2. Estimation method according to claim 1, **characterised in that** said modal decomposition is a diagonalisation and that:

   - the modal vectors of the first base and the first modal values are respectively the eigenvectors and the eigenvalues of the first matrix;
   - the modal vectors of the second base and the second modal values are respectively the eigenvectors and the eigenvalues of the second matrix.

3. Estimation method according to claim 1, **characterised in that** said modal decomposition is a decomposition into singular values and that:

   - the modal vectors of the first base and the first modal values are respectively the singular vectors and singular values of the first matrix;
   - the modal vectors of the second base and the second modal values are respectively the singular vectors and the singular values of the second matrix.

4. Estimation method according to claim 1, **characterised in that** said correspondence may be established by seeking, for each modal vector of the second base, the modal vector of the first base that is closest thereto.

5. Estimation method according to claim 1, **characterised in that** said correspondence may be established step by step between the modal vectors of the first base and the modal vectors of the second base by means of a plurality of successive operations, each association relating to an intermediate modal vector base.

6. Estimation method according to claims 1 to 5, **characterised in that** said operator is defined by $\mathbf{F} = \mathbf{Diag}(\lambda_s/\lambda'_s)$ where $\lambda_s, \lambda'_s$ are respectively the first and second modal values and **Diag(.)** is the diagonal matrix of rank s, equal to the number of modal vectors of the first/second base.

7. Estimation method according to claims 1 to 5, **characterised in that** said operator is defined by a pseudo-inverse matrix minimising the distance between $F(\lambda'^s)$ and $\lambda^s$ for a set of pairs $\lambda'^s_p$, $\lambda^s_p$, $p=1,...,P$, where $\lambda^s_p$ and $\lambda'^s_p$ are first and second modal values obtained by $P$ respective simulations of the first and second diffraction models.

8. Estimation method according to one of the preceding claims, **characterised in that**

$$\lambda'^\mu = \left( \mathbf{V}'^\mu \right)^\dagger \mathbf{a}'^\mu$$

where $\lambda'^\mu$ represents the vector of the second modal components, $(\mathbf{V}'^\mu)^+$ is the pseudo-inverse matrix of $\mathbf{V}'^\mu$, $\mathbf{V}'^\mu$ is the matrix the columns of which are said modal vectors of the second base and the rows of which correspond to the second plurality of measured ratios.

9. Estimation method according to claim 8, **characterised in that** the reconstructed vector, $\tilde{\mathbf{a}}$, is generated by:

$$\tilde{\mathbf{a}} = \mathbf{V}^s \lambda^\mu$$

where $\mathbf{V}^s$ is the matrix the columns of which are said modal vectors of the first base and the rows of which correspond to the first plurality of ratios of the first model.

10. Estimation method according to claim 9, **characterised in that** the equivalent radar cross section $(\tilde{\sigma}_{ij}^{\pi_e \pi_r})$ for a pair of incident wave and diffracted wave observation directions and a pair of associated polarisations can then be obtained from the squared modulus $(\left| \tilde{a}_{ij}^{\pi_e \pi_r} \right|^2)$ of a component of said reconstructed vector.

11. Estimation method according to one of claims 8 to 10, **characterised in that** the pseudo inverse matrix of $\mathbf{V}'^\mu$ can be obtained by $(V'^\mu)^\dagger = (V'^{\mu H} V'^\mu)^{-1} V'^{\mu H}$, the matrix $\mathbf{V}'^\mu$ previously being the subject of a matrix reconditioning if the conditioning number of the matrix $\mathbf{V}'^{\mu H} \mathbf{V}'^\mu$ is greater than a predetermined threshold ($cond_T$).

12. Computer program comprising software means adapted to carry out the steps of the estimation method, when it is executed by a computer.

modèle en champ lointain $A_b$

modèle en champ proche $A'_b$

— 110

décomposition modale de $A_b$ : $V, \lambda$

décomposition modale de $A'_b$ : $V', \lambda'$

— 120

sélection modale : $V \rightarrow V^s$

sélection modale : $V' \rightarrow V'^s$

— 130

correspondance entre vecteurs modaux

$$V_k \longleftrightarrow V'_{f(k)}$$

— 140

détermination de l'opérateur $F$

$$F\left(\lambda'^s\right) = \lambda^s$$

— 150

mesures en CP : $a'^r_k(\vec{u}_r, \pi^r)\left[a'^e_k(\vec{u}_e, \pi^e)\right]^{-1}$

$k = 1, ..., N^\mu$

— 160

$$V'^s \longrightarrow V'^\mu$$

— 170

projection base CP: $\lambda'^\mu = \left(V'^\mu\right)^\dagger a'^\mu$

— 180

passage CP → CL: $\lambda^\mu = F\left(\lambda'^\mu\right)$

— 190

reconstruction $\tilde{a} = V^s \lambda^\mu$

— 193

calcul de la SER

$$\tilde{\sigma}_{ij}^{\pi_e \pi_r} = \left|\tilde{a}_{ij}^{\pi_e \pi_r}\right|^2$$

— 195

**Fig.1**

$$s = card\ (S) \quad \boxed{}^{210}$$

$$cond\left(\mathbf{V}^{\prime\mu H}\mathbf{V}^{\prime\mu}\right) \quad \boxed{}^{220}$$

230

$$cond(.) < cond_T \quad \xrightarrow{\text{Y}} \quad \text{return} \quad \boxed{}^{280}$$

N

240

$$s = s_{min} \quad \xrightarrow{\text{Y}} \quad \text{erreur} \quad \boxed{}^{245}$$

N

détermination
de mode $\quad \boxed{}^{250}$

$$red\left(\mathbf{V}^{\prime\mu}\right) \quad \boxed{}^{260}$$

$$\lambda^{\prime\mu}_{reck} = \lambda^{\prime\mu}_{k} \quad k \in S^* \\ \lambda^{\prime\mu}_{reck} = \lambda^{\prime s}_{k} \quad k \in S - S^* \quad \boxed{}^{270}$$

$$s = s - 1 \quad \boxed{}^{280}$$

**Fig.2**

$$\delta N^{\mu} = 0 \quad \overset{\frown}{\phantom{x}} 310$$

$$cond\left(\mathbf{V}^{'\mu H}\mathbf{V}^{'\mu}\right) \quad \overset{\frown}{\phantom{x}} 320$$

330

$$cond(.) < cond_T \quad \xrightarrow{\text{Y}} \quad \boxed{\text{return}} \quad \overset{\frown}{\phantom{x}} 380$$

N

340

$$\delta N^{\mu} = \delta N^{\mu}_{\text{max}} \quad \xrightarrow{\text{Y}} \quad \boxed{\text{erreur}} \quad \overset{\frown}{\phantom{x}} 345$$

N

donnée
simulation     350

$$augm(\mathbf{a}^{'\mu}) \quad \overset{\frown}{\phantom{x}} 360$$

$$augm(\mathbf{V}^{'\mu}) \quad \overset{\frown}{\phantom{x}} 370$$

**Fig.3**

19

$$\delta N^\mu = 0 \quad \text{—} 410$$

$$cond\left(\mathbf{V}'^{\mu H}\mathbf{V}'^{\mu}\right) \quad \text{—} 420$$

$$cond(.) < cond_T \quad \text{—} 430$$

Y

N

441

overflow $\longleftarrow$ $\delta N^\mu = \delta N^\mu_{max}$ — 440

Y

N

$$\delta N^\mu = \delta N^\mu + 1 \quad \text{—} 443$$

$$Min\left[cond(.)\right] \quad \text{—} 445$$
$$(\vec{u}_e, \vec{u}_r) \quad (\pi_e, \pi_r)$$

$$cond(.) < cond_T \quad \text{—} 447$$

N

Y

$$\text{mesure(s)} \quad \text{—} 450$$
$$a'^r_k(\vec{u}_r, \pi^r)\left[a'^e_k(\vec{u}_e, \pi^e)\right]^{-1}$$

$$augm(\mathbf{a}'^\mu) \quad \text{—} 460$$

$$augm(\mathbf{V}'^\mu) \quad \text{—} 470$$

480

return

**Fig.4**

**EP 2 721 430 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• EP 2132586 B

**Littérature non-brevet citée dans la description**

• **G.T. TUCK et al.** Radar cross-section Handbook. Peninsula Publishing